# EUROPEAN PATENT SPECIFICATION

(11) **EP 0 822 067 B1**
(45) Date of publication and mention of the grant of the patent: **12.01.2000**
(21) Application number: 97201823.8
(22) Date of filing: 20.06.1997
(51) Int. Cl.: B41C 1/10

(54) **A method for producing lithographic plates by using an imaging element sensitive to IR radiation or heat**
Verfahren zur Erzeugung von lithographischen Druckplatten mit einem gegenüber Infrarot-Strahlen oder Hitze empfindlichen Bildelement
Méthode pour fabriquer des plaques lithos en utilisant un élément sensible aux rayons infrarouges ou à la chaleur

(30) Priority: 30.07.1996 EP 96202154
(43) Date of publication of application: 04.02.1998
(73) Proprietor: AGFA-GEVAERT N.V., 2640 Mortsel (BE)
(72) Inventor: Van Damme, Marc, 2640 Mortsel (BE); Vermeersch, Joan, 2640 Mortsel (BE); Kokkelenberg, Dirk, 2640 Mortsel (BE)

(56) References cited:
- WO-A-96/20429
- DE-A- 4 426 820
- US-A- 4 544 627

## Description

### 1. Field of the invention.

The present invention relates to a method for preparing a printing plate from an infrared radiation or heat sensitive material.

### 2. Background of the invention.

Lithography is the process of printing from specially prepared surfaces, some areas of which are capable of accepting lithographic ink, whereas other areas, when moistened with water, will not accept the ink. The areas which accept ink form the printing image areas and the ink-rejecting areas form the background areas.

In the art of photolithography, a photographic material is made imagewise receptive to oily or greasy ink in the photo-exposed (negative working) or in the non-exposed areas (positive working) on a hydrophilic background.

In the production of common lithographic plates, also called surface litho plates or planographic printing plates, a support that has affinity to water or obtains such affinity by chemical treatment is coated with a thin layer of a photosensitive composition. Coatings for that purpose include light-sensitive polymer layers containing diazo compounds, dichromate-sensitized hydrophilic colloids and a large variety of synthetic photopolymers. Particularly diazo-sensitized systems are widely used.

Upon imagewise exposure of such light-sensitive layer the exposed image areas become insoluble and the unexposed areas remain soluble. The plate is then developed with a suitable liquid to remove the diazonium salt or diazo resin in the unexposed areas.

At present, most of the commercial positive working printing plates are based on the quinone diazide technology. Said lithographic positive printing plates based on quinone diazide technology are obtained by UV exposure of an an imaging element comprising quinone diazide compounds and novolac compounds on a hydrophilic base and development of the exposed imaging element, thereby baring on the exposed areas the hydrophilic base. More details are given in J. Kosar, "Light sensitive Systems", John Wiley and Sons, 1965 and in numerous patents e.g. JP 05-107755, JP 04-282637, JP 04-13149, JP 03-228056, JP 03-228058, JP 03-225342, JP 03-225343, JP 03-235953, JP 03-161754, EP-A 586309, EP-A 579237, EP-A 550893, EP-A 549339, EP-A 544264, EP-A 537633, EP-A 527369, EP-A 505903, JP 04-110946, JP 04-110947, JP 03-273250, JP 03-225341, JP 04-22956, JP 03-274053, JP 03-274054, JP 03-259259, JP 03-235954, JP 03-235955, WO 91019227, DE 4,013,575, EP-A 442386, DE 4,003,025, DE 4,002,397, DE 3,940,911, JP 55-126235, EP-A 345016, EP-A 303945, EP-A 78980, EP-A 78981,

On the other hand, methods are known for making printing plates involving the use of imaging elements that are heat sensitive rather than photosensitive. A particular disadvantage of photosensitive imaging elements such as described above for making a printing plate is that they have to be shielded from the light. Furthermore they are less suited for computer-to-plate imaging. The trend towards heat sensitive printing plate precursors is clearly seen on the market.

For example, EP-A 770495, 770496, 770497 and 770494 disclose a method for making a lithographic printing plate comprising the steps of (1) image-wise exposing to light a heat sensitive imaging element comprising (i) on a hydrophilic surface of a lithographic base an image forming layer comprising hydrophobic thermoplastic polymer particles dispersed in a hydrophilic binder and (ii) a compound capable of converting light to heat, said compound being comprised in said image forming layer or a layer adjacent thereto; (2) and developing a thus obtained image-wise exposed element by rinsing it with plain water.

EP-A 625728 discloses a lithographic plate with an image forming layer which is UV- and IR-sensitive which can be as well positive as negative working. Said image forming layer comprises (1) a resole resin, (2) a novolac resin, (3) a latent Bronsted acid and (4) an IR absorber. By exposing with UV or IR (830 nm) light followed by a classical PS-plate development a positive working lithographic plate is obtained. If the plate is baked ( 60 seconds at 100°C) before the development step a negative working printing plate is obtained.

EP-A-672954 discloses a lithographic plate with an image forming layer which is UV- and IR-sensitive which can be as well positive as negative working. Said image forming layer comprises (1) a resole resin, (2) a novolac resin, (3) a haloalkyl substituted s-triazine and (4) an IR absorber. By exposing with UV or IR (830 nm) light followed by a classical PS-plate development a positive working lithographic plate is obtained. If the plate is baked ( 60 seconds at 100°C) before the development step a negative working printing plate is obtained.

US-A-5,466,557 discloses a lithographic plate with an image forming layer which is UV- and IR-sensitive which can be as well positive as negative working. Said image forming layer comprises (1) a resole resin, (2) a novolac resin, (3) a latent Bronsted acid, (4) an IR absorber and (5) terephthaldehyde. By exposing with UV or IR (830 nm) light followed by a classical PS-plate development a positive working lithographic plate is obtained. If the plate is baked ( 60 seconds at 100°C) before the development step a negative working printing plate is obtained.

US-P 4,708,925 discloses a positive working printing plate comprising a light sensitive composition comprising (1) an alkali-soluble novolac resin and an onium-salt and optionally an IR spectral sensitizing dye. By exposing with UV, visible or IR light followed by a development step with an alkali solution there is obtained a positive working printing plate.

DE-A-4,426,820 discloses a method for obtaining a negative working lithographic printing plate comprising the steps of:
(a) overall exposing to actinic light an imaging element comprising on a hydrophilic surface of a lithographic base an IR radiation or heat sensitive layer comprising a quinone diazide and an additive that, when heated with a photoreactionproduct of the quinone diazide forms an alkali insoluble material, actinic light being light which makes said quinone diazide soluble in an alkali developer
(b) image-wise heating of the imaging element ;
(c) developing said overall exposed to actinic lightand image-wise heated imaging element with an aqueous alkaline developing solution in order to remove the non-heated areas and thereby form a lithographic printing plate. The quality of said plates could use some improvement.

WO-96/20429 discloses a method of forming a lithographic plate by the heat-mode imaging method which comprises coating on a lithographic base a positive working photosensitive composition which comprises a naphthoquinone diazide ester of a phenolic resin or a naphthoquinone diazide ester and a phenolic resin and at least one substance which absorbs infrared radiation, overall exposing the assembly to ultraviolet light to render the photosensitive composition developable, imaging the plate by means of a laser which emits in the infrared region of the spectrum and then developing the plate to remove these areas of the photosensitive composition not exposed to the laser. The quality of said plates could use some improvement.

US-A-4,544,627 discloses a negative working image forming process which comprises uniformly exposing a photosensitive material comprising a support having thereon a sensitive layer comprising (i) an quinonediazide and (ii) a second compound , to actinic light which is able to convert the quinonediazide to the corresponding indenecarboxylic acid , and subsequently exposing imagewise said material to a laser beam and developing with an alkaline developing solution to dissolve out the unexposed area to the laser beam. The quality of said plates could use some improvement.

There remains a need for an imaging element, which can be imaged by image-wise exposure to IR irradiation or heat and does not require a troublesome overall heating and which is negative working.

### 3. Summary of the invention.

It is an object of the present invention to provide a method for obtaining in a convenient way a negative working lithographic printing plate of a high quality using an imaging element which is practically insensitive to room-light.

Further objects of the present invention will become clear from the description hereinafter.

According to the present invention there is provided a method for obtaining a negative working lithographic printing plate comprising the steps of:
(a) image-wise or information-wise exposing to IR light or heat an imaging element comprising on a hydrophilic surface of a lithographic base an IR radiation or heat sensitive layer comprising a quinone diazide, a water insoluble, alkali soluble or swellable resin and an infrared absorber,
b) overall exposing the imaging element with UV light after the image-wise or information-wise exposure of the imaging element to provide increased solubility in the image-wise or information-wise unexposed areas;
(c) developing said image-wise or information wise and overall exposed imaging element with an aqueous alkaline developing solution in order to remove the image-wise or information-wise unexposed areas and thereby form a lithographic printing plate.

### 4. Detailed description of the invention.

It has been found that negative working lithographic printing plates of high quality can be obtained according to the method of the present invention using an imaging element as described above.

To obtain a negative-working plate requires in one embodiment the steps of imagewise exposure of the imaging element according to the invention to IR radiation or heat, overall exposure to UV radiation of the imagewise exposed imaging element to provide increased solubility in the imagewise unexposed areas and contact with an aqueous alkaline processing solution to remove imagewise unexposed areas.

Of course, it is still possible to use the imaging element according to the invention as a positive working imaging element by image-wise exposing the imaging element to UV radiation and developing it with an aqueous alkaline processing solution to remove the image-wise exposed areas.

The quinone diazide according to the invention is preferably a 4- or 5- sulphonyl or carboxyl substituted 1,2 naphthoquinone diazides (NQD). Particularly preferred are o-naphthoquinonediazidosulphonic acid esters or o-naphthoquinone diazidocarboxylic acid esters of various hydroxyl compounds; and o-naphthoquinonediazidosulphonic acid amides or o-naphthoquinonediazidocarboxylic acid amides of various aromatic amine compounds.

Two variants of the application of NQD can be distinguished: (1) one-component systems, (2) two-component systems. In the former case, the sulphonic or carboxyl acid group is linked directly to the phenolic hydroxy group of a water insoluble, alkali soluble or swellable resins having a phenolic hydroxy group. For a good function of such polymer it is important that some phenolic hydroxy groups remain unsubstituted. Examples of such phenols include phenol, cresol, resorcin and pyrogallol. Examples of preferred water insoluble, alkali soluble or swellable resins having a phenolic hydroxy group include phenol-formaldehyde resin, cresol-formaldehyde resin, pyrogallol-acetone resin and resorcin-benzaldehyde resin.

Typical examples of o-quinonediazide compounds include esters of benzoquinone-(1,2)-diazidosulphonic acid or napthoquinone-(1,2)-diazidosulphonic acid and phenol-formaldehyde resin or cresol-formaldehyde resin; ester of naphthoquinone-(1,2)-diazido-(2)-5-sulphonic acid and pyrogallol-acetone resin as disclosed in U.S. Patent No. 3,635,709; and ester of naphthoquinone-(1,2)-diazido-(2)-5-sulphonic acid and resorcin-pyrogallol-acetone copolycondensates as disclosed in J.P. KOKAI No. Sho 55-76346.

Examples of other useful o-quinonediazide compounds are polyesters having hydroxyl groups at their termini esterified with o-napthoquinonediazidesulphonyl chloride as disclosed in J.P. KOKAI No. Sho 50-117503; homopolymers of p-hydroxystyrene or copolymers thereof with other copolymerizable monomers esterified with o-naphtoquinonediazidosulphonyl chloride as disclosed in J.P. KOKAI No. Sho 50-113305; ester of bisphenol-formaldehyde resin and o-quinonediazidosulphonic acid as disclosed in J.P. KOKAI No. Sho 54-29922; condensates of alkyl acrylate-acryloyloxyalkyl carbonate - hydroxyalkyl acrylate copolymers with o-naphthoquinonediaziosulphonyl chloride as disclosed in U.S. Patent No. 3,859,099; reaction products of copolymerized products of styrene and phenol derivatives with o-quinonediazidosulphonic acid as disclosed in J.P. KOKOKU No. Sho 49-17481; amides of copolymers of p-aminostyrene and monomers copolymerizable therewith and o-naphthoquinonediazidosulphonic acid or o-naphthoquinonediazidocarboxylic acid as disclosed in U.S. Patent No. 3,759,711; as well as ester compounds of polyhydroxybenzophenone and o-naphthoquinonediazidosulphonyl chloride.

These o-quinonediazide compounds may be used alone and fulfil then the function of the quinone diazide and the water insoluble, alkali soluble or swellable resin, but are preferably used as a mixture with an alkalki-soluble resin to form a light-sensitive layer.

In the application of NQD as two-component systems various low-molecular NQD sulphonic or carboxyl acid derivatives are dissolved mainly in certain water insoluble, alkali soluble or swellable resins; the latter acts as polymeric binder for NQD. Preferably said 4- or 5- sulphonyl or carboxyl substituted 1,2 naphthoquinonediazides are esters of 1,2 naphthoquinonediazides-4-or -5- sulphonic or carboxylic acids with a phenolic compound having at least two phenolic hydroxy groups, more preferably with a phenolic compound having at least three phenolic hydroxy groups. Further suitable 1,2 naphthoquinone-2-diazides are disclosed in GB-A 739654 and in US-A 4,266,001.

Preferred water insoluble, alkali soluble or swellable resins are resins, which pro gram comprises 1 to 15 mmole of phenolic hydroxy groups, oxime groups or sulphonamido groups. More preferred are resins having phenolic hydroxy groups, for example synthetic polyvinylfenols such as MARUKA LYNCUR M, a registered trade mark of Dyno Cyanamid and phenolic hydroxy functionalized derivatives of poly(meth)acrylates, which can be synthesized starting from e.g. hydroxyethyl(meth)acrylate.

Most preferred are synthetic novolac resins and typical examples thereof are phenolformaldehyde resin, cresol-formaldehyde resin, and phenol-cresol-formaldehyde copolycondensed resins as disclosed in J.P. KOKAI No. Sho 55-57841. Such synthetic novolac resins are sold as ALNOVOL, a registered trade mark of Reichold Hoechst and DUREZ, a registered trade mark of OxyChem. Still more preferably, the foregoing phenol resins are simultaneously used with a condensate of phenol or cresol substituted with an alkyl group having 3 to 8 carbon atoms and formaldehyde such as t-butylphenol-formaldehyde, as described in J.P. KOKAI No. Sho 50-125806.

Moreover, it is also possible to optionally incorporate, into the light-sensitive composition, alkali-soluble polymers other than the above listed alkali-soluble resins. Examples of such polymers are styrene-acrylic acid copolymer, methyl methacrylate-methacrylic acid copolymer, alkali-soluble polyurethane resin, and alkali-soluble vinylic resins and alkali-soluble polybutyral resins as disclosed in J.P. KOKOKU No. Sho 52-28401.

The amount of the o-quinonediazide compounds is preferably 5 to 80 % by weight and more preferably 10 to 50 % by weight based on the total weight of the solid contents of the light-sensitive composition. On the other hand, that of the alkali-soluble resins is preferably 30 to 90 % by weight and more preferably 50 to 85 % by weight based on the total weight of the solid contents of the light-sensitive composition.

A photosensitive layer in connection with this invention may be applied in the form of a multilayered structure. Moreover, the light-sensitive composition in the photosensitive layer or multi-layer package may further comprise optional components such as colorants, stabilizers, additional sensitizers, exposure indicators, surfactants, plasticizers and components for imparting printing-out properties (ability of providing a visible image immediately after imagewise exposure).

The coated amount of a photosensitive layer applied onto the hydrophilic surface of a support preferably ranges from 0.1 to 7 g/m² and more preferably from 0.5 to 4 g/m².

Another essential ingredient of the radiation-sensitive composition of this invention is an infrared absorber. The infrared absorber renders the composition sensitive to infrared radiation and makes the printing plate useful as a direct laser addressable plate which can be imaged by exposure to a laser which emits in the infrared region.

The infrared absorber can be a dye or pigment. A very wide range of such compounds is well known in the art and includes dyes or pigments of the squarylium, croconate, cyanine, merocyanine, indolizine, pyrylium, metal dithiolene, carbon black, metal boride, metal carbide, metal carbonitride and conductive polymer particle classes.

Additional infrared absorbers that are of utility in this invention include those described in U.S. Patent 5,166,024, issued November 24, 1992. As described in the '024 patent, particularly useful infrared absorbers are phthalocyanine pigments. The amount of the infrared absorber is preferably 1 to 30 % by weight and more preferably 2 to 10 % by weight based on the total weight of the solid contents of the light-sensitive composition.

To form the radiation sensitive imaging element, the quinone diazide, the water insoluble, alkali soluble or swellable resin, the infrared absorber and other optional ingredients are dissolved or dispersed in a suitable solvent in appropriate proportions and coated on the support using such well-known coating techniques as spin coating or hopper coating. Preferred solvents include acetone, methylethylketone and 1-methoxy-2-propanol.

Suitable conditions for drying the layer involve heating for a period of from 0.5 to 10 minutes at a temperature in the range of from 20 °C to 150 °C.

According to one embodiment of the present invention, the lithographic base can be an anodised aluminum support. A particularly preferred lithographic base is an electrochemically grained and anodised aluminum support. According to the present invention, an anodised aluminum support may be treated to improve the hydrophilic properties of its surface. For example, the aluminum support may be silicated by treating its surface with sodium silicate solution at elevated temperature, e.g. 95°C. Alternatively, a phosphate treatment may be applied which involves treating the aluminum oxide surface with a phosphate solution that may further contain an inorganic fluoride. Further, the aluminum oxide surface may be rinsed with a citric acid or citrate solution. This treatment may be carried out at room temperature or can be carried out at a slightly elevated temperature of about 30 to 50°C. An interesting treatment involves treating the aluminum oxide surface with polyvinyl phosphonic acid as disclosed in DE-OS 2,607,207. A further interesting treatment involves rinsing the aluminum oxide surface with a bicarbonate solution. It is further evident that one or more of these post treatments may be carried out alone or in combination.

According to another embodiment in connection with the present invention, the lithographic base comprises a flexible support, such as e.g. paper or plastic film, provided with a cross-linked hydrophilic layer. A particularly suitable cross-linked hydrophilic layer may be obtained from a hydrophilic binder cross-linked with a cross-linking agent such as formaldehyde, glyoxal, polyisocyanate or a hydrolysed tetra-alkylorthosilicate. The latter is particularly preferred.

As hydrophilic binder there may be used hydrophilic (co)polymers such as for example, homopolymers and copolymers of vinyl alcohol, acrylamide, methylol acrylamide, methylol methacrylamide, acrylic acid, methacrylic acid, hydroxyethyl acrylate, hydroxyethyl methacrylate or maleic anhydride/vinylmethylether copolymers. The hydrophilicity of the (co)polymer or (co)polymer mixture used is preferably the same as or higher than the hydrophilicity of polyvinyl acetate hydrolyzed to at least an extent of 60 percent by weight, preferably 80 percent by weight.

The amount of crosslinking agent, in particular of tetraalkyl orthosilicate, is preferably at least 0.2 parts by weight per part by weight of hydrophilic binder, preferably between 0.5 and 5 parts by weight, more preferably between 1.0 parts by weight and 3 parts by weight.

A cross-linked hydrophilic layer in a lithographic base used in accordance with the present embodiment preferably also contains substances that increase the mechanical strength and the porosity of the layer. For this purpose colloidal silica may be used. The colloidal silica employed may be in the form of any commercially available water-dispersion of colloidal silica for example having an average particle size up to 40 nm, e.g. 20 nm. In addition inert particles of larger size than the colloidal silica can be added e.g. silica prepared according to Stöber as described in J. Colloid and Interface Sci., Vol. 26, 1968, pages 62 to 69 or alumina particles or particles having an average diameter of at least 100 nm which are particles of titanic dioxide or other heavy metal oxides. By incorporating these particles the surface of the cross-linked hydrophilic layer is given a uniform rough texture consisting of microscopic hills and valleys, which serve as storage places for water in background areas.

The thickness of a cross-linked hydrophilic layer in a lithographic base in accordance with this embodiment may vary in the range of 0.2 to 25 µm and is preferably 1 to 10 µm.

Particular examples of suitable cross-linked hydrophilic layers for use in accordance with the present invention are disclosed in EP-A 601240, GB-P-1419512, FP-P-2300354, US-P-3971660, US-P-4284705 and EP-A 514490.

As flexible support of a lithographic base in connection with the present embodiment it is particularly preferred to use a plastic film e.g. substrated polyethylene terephthalate film, cellulose acetate film, polystyrene film, polycarbonate film etc... The plastic film support may be opaque or transparent.

It is particularly preferred to use a polyester film support to which an adhesion improving layer has been provided. Particularly suitable adhesion improving layers for use in accordance with the present invention comprise a hydrophilic binder and colloidal silica as disclosed in EP-A 619524, EP-A 620502 and EP-A 619525. Preferably, the amount of silica in the adhesion improving layer is between 200 mg per m² and 750 mg per m². Further, the ratio of silica to hydrophilic binder is preferably more than 1 and the surface area of the colloidal silica is preferably at least 300 m² per gram, more preferably at least 500 m² per gram.

The lithographic printing plates of this invention can be image-wise exposed with a heating device such as a heating head or with a laser which emits radiation in the near-infrared region or the infrared region of the spectrum, e.g. emits in the wavelength range 700 - 1500 nm. Preferably laser diodes are used. Such laser diodes provide the advantage of both low cost and low energy consumption.

As described hereinabove, the imagewise-exposed plate is overall exposed to UV light after the image-wise exposure. The lithographic printing plates can also be exposed with conventional ultraviolet radiation sources, including carbon arc lamps, mercury vapor lamps, fluorescent lamps, tungsten filament lamps and photoflood lamps. After the image-wise and overall exposure is completed, the plate is then either hand processed or machine processed in an aqueous alkaline developing solution until the non-image areas are removed. This typically requires 5 to 120 seconds. A preferred aqueous alkaline developing solution is a silicate solution such as a six percent by weight aqueous solution of sodium meta-silicate. A suitable commercially available silicate solution for this purpose is Fuji PS-plate developer DP-5 which is sold by Fuji Company or Sun Wipe-on developer which is sold by Koyo Chemicals Inc.. After contact with the aqueous alkaline developing solution, the plate is usually treated with a finisher such as gum arabic.

The number of printing impressions obtainable is primarily dependent upon use of a post development baking step. If no such baking step is used, the plate typically provides 60000 to 70000 impressions, whereas post development baking for 5 minutes at 250 °C typically provides 300000 to 350000 impressions. The number of impressions that can be attained before wear is detected can also be increased by increasing the coating weight.

Since the printing plate of this invention is infrared light sensitive, digital imaging information can be conveniently utilized to form continuous or halftone images using a suitable source of infrared radiation such as a laser diode emitting in the infrared region. Since the printing plate of this invention is also ultraviolet light sensitive, it can also be conveniently imaged so as to form continuous or halftone images by ultraviolet light exposure through a suitable imaging master such as a silver halide film.

The following examples illustrate the present invention without however, limiting it thereto. All parts, percentages and ratios are by weight unless otherwise indicated.

### EXAMPLE 1

### Preparation of the lithographic base

A 0.20 mm thick aluminum foil was degreased by immersing the foil in an aqueous solution containing 5 g/l of sodium hydroxide at 50°C and rinsed with demineralized water. The foil was then electrochemically grained using an alternating current in an aqueous solution containing 4 g/l of hydrochloric acid, 4 g/l of hydroboric acid and 5 g/l of aluminum ions at a temperature of 35°C and a current density of 1200 A/m² to form a surface topography with an average center-line roughness Ra of 0.5 µm.
After rinsing with demineralized water the aluminum foil was then etched with an aqueous solution containing 300 g/l of sulfuric acid at 60°C for 180 seconds and rinsed with demineralized at 25°C for 30 seconds.
The foil was subsequently subjected to anodic oxidation in an aqueous solution containing 200 g/l of sulfuric acid at a temperature of 45°C, a voltage of about 10 V and a current density of 150 A/m² for about 300 seconds to form an anodic oxidation film of 3.00 g/m² of Al₂O₃, then washed with demineralized water, posttreated with a solution containing 20 g/l of sodium bicarbonate at 40°C for 30 seconds, subsequently rinsed with demineralized water at 20°C during 120 seconds and dried.

### Preparation of the lithographic printing plate

A photosensitive composition was prepared by mixing 20 ml of SUN WIPE ON POSITIVE SENSITIZER PC-22 PART A (50 % solution in ethylene glycol monomethylether acetate containing 30 % of an o-quinonediazide resin, 19.5 % of a phenol resin commercially available from KOYO CHEMICALS INC.), 80 ml of 1-methoxy-2-propanol and 0.4 ml of SUN WIPE ON POSITIVE SENSITIZER PC-22 PART B (a visible light absorbing dye solution commercially available from KOYO CHEMICALS INC.).
This photosensitive composition was coated on the lithographic aluminum base with a wet layer thickness of 20 µm and dried.
The photosensitive printing plate was subjected to a scanning diode-laser emitting at 830 nm (scanspeed 1.1 m/s, spot size 15 µm and the power on plate surface was varied from 60 to 120 mW ). After IR-laser exposure the printing plate was overall exposed with ultraviolet light by means of a contact exposure (1000 units DL2000).
After imaging the plate was processed with Sun Wipe-on developer( an alkaline PS-plate developer commercially available from KOYO CHEMICALS INC.. The exposed and non-exposed areas were removed during the development resulting in a useless printing plate.

### EXAMPLE 2

To 20 g of the photosensitive composition of example 1 was added 0.12 g of IR-1. and 1,08 g 1-methoxy-2-propanol. This IR-sensitive composition was coated on the lithographic aluminum base with a wet layer thickness of 20 µm and dried.
The photosensitive printing plate was subjected to a scanning diode-laser emitting at 830 nm (scanspeed 1.1 m/s, spot size 10 µm and the power on plate surface was varied from 60 to 120 mW ). After IR-laser exposure the printing plate was overall exposed with a ultraviolet contact exposure (1000 units DL2000).
The imaging element was then processed with Sun Wipe-on developer to remove the IR-unexposed areas resulting in a negative working lithographic printing plate.
The obtained image on the lithographic base could be used to print on a conventional offset press using a commonly employed ink and fountain. Excellent copies were obtained.

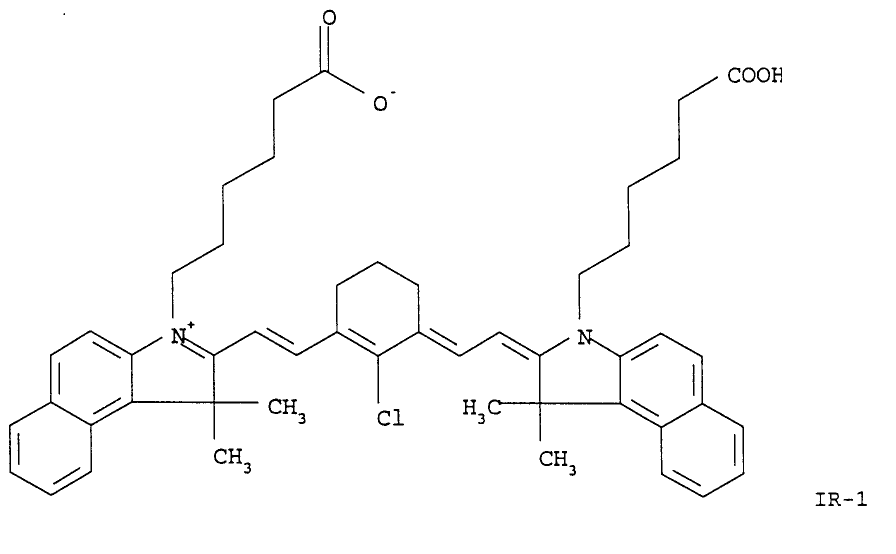

### EXAMPLE 3

On top of the lithographic printing plate from example 2 was placed in face-to-face contact a test target with a 60 cm lines per cm screen as well as fine positive and negative lines, and the imaging element was exposed therethrough to ultraviolet radiation.
The imaging element was then processed with Sun Wipe-on developer to remove the exposed areas resulting in a positive working lithographic printing plate.
The obtained image on the lithographic base could be used to print on a conventional offset press using a commonly employed ink and fountain. Excellent copies were obtained.

### EXAMPLE 4

To 20 g of the photosensitive composition of example 1 was added 0.12 g of IR-2. and 1,08 g 1-methoxy-2-propanol. This IR-sensitive composition was coated on the lithographic aluminum base with a wet layer thickness of 20 µm and dried.
The photosensitive printing plate was subjected to a scanning NdYlf-laser emitting at 1050 nm (scanspeed 4.4 m/s, spot size 15 µm and the power on plate surface was varied from 75 to 475 mW ). After IR-laser exposure the printing plate was overall exposed with a ultraviolet contact exposure (1000 units DL2000).
The imaging element was then processed with Sun Wipe-on developer to remove the IR-unexposed areas resulting in a negative working lithographic printing plate.
The obtained image on the lithographic base could be used to print on a conventional offset press using a commonly employed ink and fountain. Excellent copies were obtained.

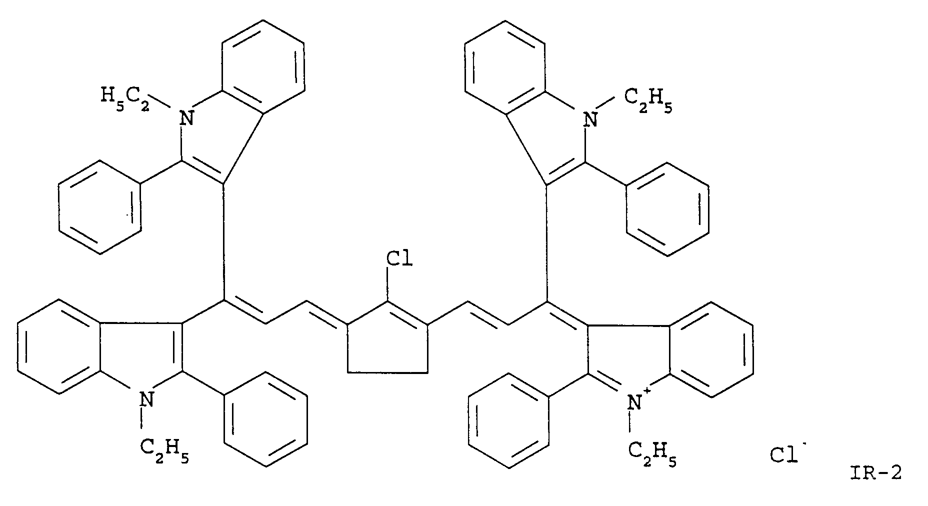

### EXAMPLE 5

On top of the lithographic printing plate from example 4 was placed in face-to-face contact a test target with a 60 cm lines per cm screen as well as fine positive and negative lines, and the imaging element was exposed therethrough to ultraviolet radiation.
The imaging element was then processed with Sun Wipe-on developer to remove the exposed areas resulting in a positive working lithographic printing plate.
The obtained image on the lithographic base could be used to print on a conventional offset press using a commonly employed ink and fountain. Excellent copies were obtained.

### EXAMPLE 6 (COMPARATIVE)

The photosensitive printing plate from example 4 was first overall exposed with an ultraviolet contact exposure (1000 units DL 2000). After this overall ultraviolet exposure the printing plate was subjected to a scanning NdYlf-laser emitting at 1050 nm (scanspeed 4.4 m/s, spot size 15 µm and the power on plate surface was varied from 75 to 475 mW ).
The imaging element was then processed with Sun Wipe-on developer to remove the IR-unexposed areas resulting in a negative working lithographic printing plate.
The obtained image on the lithographic base could be used to print on a conventional offset press using a commonly employed ink and fountain. Excellent copies were obtained.

## Claims

1. A method for obtaining a negative working lithographic printing plate comprising the steps of:
(a) image-wise or information-wise exposing to IR light or heat an imaging element comprising on a hydrophilic surface of a lithographic base an IR radiation or heat sensitive layer comprising a quinone diazide, a water insoluble, alkali soluble or swellable resin and an infrared absorber,
b) overall exposing the imaging element with UV light after the image-wise or information-wise exposure of the imaging element to provide increased solubility in the image-wise or information-wise unexposed areas;
(c) developing said image-wise or information wise and overall exposed imaging element with an aqueous alkaline developing solution in order to remove the image-wise or information-wise unexposed areas and thereby form a lithographic printing plate.

2. A method for obtaining a negative working lithographic printing plate according to claim 1 wherein said quinone diazide is a 4- or 5- sulphonyl or carboxyl substituted 1,2-naphthoquinone diazide.

3. A method for obtaining a negative working lithographic printing plate according to claim 2 wherein the sulphonic or carboxyl acid group of said 4- or 5- sulphonyl or carboxyl substituted 1,2-naphthoquinone diazide is linked directly to the phenolic hydroxy group of a water insoluble, alkali soluble or swellable resins having a phenolic hydroxy group.

4. A method for obtaining a negative working lithographic printing plate according to claim 2 wherein said 4- or 5- sulphonyl or carboxyl substituted 1,2-naphthoquinone diazide is an ester of 1,2 naphthoquinonediazide-4- or -5- sulphonic or carboxylic acid with a phenolic compound having at least two phenolic hydroxy groups.

5. A method for obtaining a negative working lithographic printing plate according to claim 4 wherein said 4- or 5- sulphonyl or carboxyl substituted 1,2-naphthoquinone diazide is an ester of 1,2 naphthoquinonediazide-4- or -5- sulphonic or carboxylic acid with a phenolic compound having at least three phenolic hydroxy groups.

6. A method for obtaining a negative working lithographic printing plate according to any of claims 1 to 5 wherein said water insoluble, alkali soluble or swellable resin is a resin having phenolic hydroxy groups.

7. A method for obtaining a negative working lithographic printing plate according to claim 6 wherein said resin having phenolic hydroxy groups is a synthetic novolac resin.

8. A method for obtaining a negative working lithographic printing plate according to any of claims 1 to 7 wherein said infrared absorber is a dye or pigment selected from the group consisting of squarylium, croconate, cyanine, merocyanine, indolizine, pyrylium, metal dithiolene, carbon black, metal boride, metal carbide, metal carbonitride and conductive polymer particle compounds.

## Patentansprüche

1. Verfahren zur Herstellung einer negativwirkenden lithografischen Druckplatte, mit folgenden Stufen :
(a) die bildmäßige oder informationsmäßige Belichtung mittels Infrarotlicht oder Wärme eines bilderzeugenden Elements, das auf einer hydrophilen Oberfläche einer lithografischen Unterlage eine für Infrarotstrahlung empfindliche oder wärmeempfindliche Schicht mit einem Chinondiazid, einem wasserunlöslichen, alkalilöslichen oder alkaliquellbaren Harz und einem Infrarotabsorptionsmittel enthält,
b) die Gesamtbelichtung des bilderzeugenden Elements mit Ultraviolettlicht nach der bildmäßigen oder informationsmäßigen Belichtung des bilderzeugenden Elements, um die Löslichkeit in den nicht bildmäßig oder informationsmäßig belichteten Bereichen zu verbessern,
(c) die Entwicklung des einer bildmäßigen oder informationsmäßigen Belichtung und einer Gesamtbelichtung unterzogenen bilderzeugenden Elements mit einer wäßrigen alkalischen Entwicklerlösung, um die nicht bildmäßig oder informationsmäßig belichteten Bereiche zu entfernen und dabei eine lithografische Druckplatte zu erzeugen.

2. Verfahren zur Herstellung einer negativwirkenden lithografischen Druckplatte nach Anspruch 1, dadurch gekennzeichnet, daß das Chinondiazid ein 4- oder 5-sulfonyl- oder -carboxylsubstituiertes 1,2-Naphthochinondiazid ist.

3. Verfahren zur Herstellung einer negativwirkenden lithografischen Druckplatte nach Anspruch 2, dadurch gekennzeichnet, daß die Sulfonsäure- oder Carbonsäuregruppe des 4- oder 5-sulfonyl- oder -carboxylsubstituierten 1,2-Naphthochinondiazids direkt an die phenolische Hydroxygruppe eines wasserunlöslichen, alkalilöslichen oder alkaliquellbaren Harzes mit einer phenolischen Hydroxygruppe gebunden ist.

4. Verfahren zur Herstellung einer negativwirkenden lithografischen Druckplatte nach Anspruch 2, dadurch gekennzeichnet, daß das 4- oder 5-sulfonyl- oder -carboxylsubstituierte 1,2-Naphthochinondiazid ein Ester von 1,2-Naphthochinondiazid-4-oder-5-sulfonsäure oder -carbonsäure mit einer Phenolverbindung mit wenigstens zwei phenolischen Hydroxygruppen ist.

5. Verfahren zur Herstellung einer negativwirkenden lithografischen Druckplatte nach Anspruch 4, dadurch gekennzeichnet, daß das 4- oder 5-sulfonyl- oder -carboxylsubstituierte 1,2-Naphthochinondiazid ein Ester von 1,2-Naphthochinondiazid-4-oder-5-sulfonsäure oder -carbonsäure mit einer Phenolverbindung mit wenigstens drei phenolischen Hydroxygruppen ist.

6. Verfahren zur Herstellung einer negativwirkenden lithografischen Druckplatte nach irgendeinem der Ansprüche 1 bis 5, dadurch gekennzeichnet, daß das wasserunlösliche, alkalilösliche oder alkaliquellbare Harz ein Harz mit phenolischen Hydroxygruppen ist.

7. Verfahren zur Herstellung einer negativwirkenden lithografischen Druckplatte nach Anspruch 6, dadurch gekennzeichnet, daß das Harz mit phenolischen Hydroxygruppen ein synthetisches Novolakharz ist.

8. Verfahren zur Herstellung einer negativwirkenden lithografischen Druckplatte nach irgendeinem der Ansprüche 1 bis 7, dadurch gekennzeichnet, daß die Infrarotlicht absorbierende Substanz ein Farbstoff oder ein Pigment aus der Gruppe bestehend aus Squarylium-, Krokonat-, Cyanin-, Merocyanin-, Indolizin-, Pyrylium-, Metalldithiolen-, Gasruß-, Metallborid-, Metallcarbid- und Metallcarbonitridverbindungen und Verbindungen mit Teilchen eines leitfähigen Polymeren ist.

## Revendications

1. Procédé pour obtenir un cliché d'impression lithographique à traitement négatif, comprenant les étapes consistant à:
(a) exposer en forme d'image ou en forme d'informations à de la lumière infrarouge ou à de la chaleur un élément de formation d'image comprenant, sur une surface hydrophile d'une base lithographique, une couche sensible au rayonnement infrarouge ou sensible à la chaleur comprenant un quinonediazide, une résine insoluble dans l'eau, soluble ou apte à gonfler dans les alcalis, ainsi qu'un agent absorbant l'infrarouge;
(b) exposer globalement l'élément de formation d'image à de la lumière ultraviolette après l'exposition en forme d'image ou en forme d'informations de l'élément de formation d'image pour augmenter la solubilité dans les zones non exposées en forme d'image ou en forme d'informations;
(c) développer ledit élément de formation d'image exposé en forme d'image ou en forme d'informations et soumis à une exposition globale, avec une solution développatrice alcaline aqueuse dans le but d'éliminer les zones non exposées en forme d'image ou en forme d'informations et d'ainsi obtenir un cliché d'impression lithographique.

2. Procédé pour obtenir un cliché d'impression lithographique à traitement négatif selon la revendication 1, dans lequel ledit quinonediazide est un 1,2-naphtoquinone-diaazide portant un ou plusieurs substituants sulfonyle ou carboxyle identiques ou différents en position 4 ou en position 5.

3. Procédé pour obtenir un cliché d'impression lithographique à traitement négatif selon la revendication 2, dans lequel le groupe d'acide sulfonique ou d'acide carboxylique dudit 1,2-naphtoquinone-diazide portant un ou plusieurs substituants sulfonyle ou carboxyle en position 4 ou en position 5 est lié directement au groupe hydroxyle phénolique d'une résine insoluble dans l'eau, soluble ou apte à gonfler dans des alcalis, contenant un groupe hydroxyle phénolique.

4. Procédé pour obtenir un cliché d'impression lithographique à traitement négatif selon la revendication 2, dans lequel ledit 1,2-naphtoquinone-diazide portant un ou plusieurs substituants sulfonyle ou carboxyle en position 4 ou en position 5 est un ester de l'acide 1,2-naphtoquinonediazide-4- ou 5-sulfonique ou carboxylique avec un composé phénolique contenant au moins deux groupes hydroxyle phénoliques.

5. Procédé pour obtenir un cliché d'impression lithographique à traitement négatif selon la revendication 4, dans lequel ledit 1,2-naphtoquinone-diazide portant un ou plusieurs substituants sulfonyle ou carboxyle en position 4 ou en position 5 est un ester de l'acide 1,2-naphtoquinone-diazide-4- ou 5-sulfonique ou carboxylique avec un composé phénolique contenant au moins trois groupes hydroxyle phénoliques.

6. Procédé pour obtenir un cliché d'impression lithographique à traitement négatif selon l'une quelconque des revendications 1 à 5, dans lequel ladite résine insoluble dans l'eau, soluble ou apte à gonfler dans les alcalis est une résine contenant des groupes hydroxyle phénoliques.

7. Procédé pour obtenir un cliché d'impression lithographique à traitement négatif selon la revendication 6, dans lequel ladite résine contenant des groupes hydroxyle phénoliques est une résine synthétique de novolaque.

8. Procédé pour obtenir un cliché d'impression lithographique à traitement négatif selon l'une quelconque des revendications 1 à 7, dans lequel ledit agent absorbant l'infrarouge est un colorant ou un pigment choisi parmi le groupe constitué par le squarylium, le croconate, la cyanine, la mérocyanine, l'indolizine, le pyrylium, un dithiolène métallique, le noir de carbone, du borure métallique, du carbure métallique, du carbonitrure métallique, ainsi que des composés sous la forme de particules polymères conductrices.
